Europäisches Patentamt

(18) European Patent Office  (11) Publication number: **0 081 000**

Office européen des brevets  **A1**

(12) **EUROPEAN PATENT APPLICATION**

(21) Application number: **81110116.1**  (51) Int. Cl.³: **G 01 R 29/12**
**H 01 T 19/00**

(22) Date of filing: **03.12.81**

(43) Date of publication of application:
**15.06.83 Bulletin 83/24**

(84) Designated Contracting States:
**BE DE FR GB IT**

(71) Applicant: **POLAROID CORPORATION**
549 Technology Square
Cambridge, Massachusetts 02139(US)

(72) Inventor: **Kisler, Semyon**
18 Vincent Street
West Newton Massachusetts 02165(US)

(74) Representative: **Wallach, Curt, Dipl.-Ing. Patentanwälte**
Dipl.-Ing. C.Wallach et al,
Dipl.-Ing. G. Koch Dr.T.Haibach Dipl.-Ing. R. Feldkamp
Kaufingerstrasse 8
D-8000 München 2(DE)

(54) **Corona detection apparatus.**

(57) The presence (or absence) of corona is detected by inserting an electrical conductor into the path of spatial current produced by said corona and monitoring the conductor current that is produced by corona-generated electric charges impinging on said electrical conductor.

FIG. 2A

EP 0 081 000 A1

## Description

## Corona Detection Apparatus

### Field of the Invention

The invention relates to apparatus for detecting the presence of corona, in general, and to apparatus for detecting the presence of corona controlling electrostatic charges on a moving web of charge-retaining material, in particular.

### Description of the Prior Art

The presence of electrostatic charges on charge-retaining materials causes many problems. In photography, for example, electrostatic charges on film units stacked within a film cassette could cause clinging of the film units to one another with such intensity that proper ejection of a film unit from the cassette may be prevented if the effects of such charges are not controlled. Such electrostatic charges may be controlled by controlling the charge levels on components of the film prior to final film unit assembly.

One technique for controlling electrostatic charges in charge-retaining materials comprises the establishing a corona between an electrode and a reference surface spaced from said electrode and the passing of the material through the spatial current path produced by the corona. This technique is widely used and is quite effective for regulating electrostatic charges in such materials. However, in order properly to employ corona in this manner for electrostatic charge control, it is necessary to provide for a reliable source of corona to avoid any interruption in the eletrostatic charge controlling process.  Current practices for insuring the presence of a corona employ at least two corona sources, one source supplying charge controlling corona to a moving web, for example, the other source, spaced from the first corona source in the direction of web movement, being maintained in a deenergized state and capable of supplying the same electrostatic charge controlling corona level to the moving web when it is energized.  An operator monitors voltmeter and current meter of the power supply of the active corona source.  Deviations in the readings of the voltmeter and/or ammeter from a predetermined range or set of ranges are considered to be an indication of corona-loss. In such a situation the standby corona source is immediately activated to continue the process of controlling the electrostatic charge on the moving web, without interruption.

Not only is it an obvious disadvantage to monitor a machine by an operator, but also neither ammeter nor volmeter indications are always reliable indications of corona loss.  Sometimes a particular ammeter and/or voltmeter may indicate the presence of an active corona source when, in fact, no corona is present.  Not only does this interrupt the charge controlling process, it is also difficult and costly to determine readily which portions of the moving web have not been properly charged, and subsequently to charge these portions, especially in a high-volume, time-oriented production setting.

Summary of the Invention

In accordance with the present invention apparatus is provided for detecting the presence and, conversely, the absence of corona. An electrical conductor is positioned within the current path produced by a corona and means are provided for sensing in the conductor current resulting from corona-current charges striking or impinging on said conductor. The corona detection apparatus of the present invention detects any loss of corona used to control electrostatic charges on a moving web of charge-retaining material. The apparatus includes means for substituting an equivalent corona source for the defective source whenever a loss of corona is detected.

Brief Description of the Drawings

Figure 1 is a schematic diagram, in elevation, of a moving web being subjected to electrostatic charge controlling corona in accordance with the prior art.

Fig. 2A is a schematic diagram, in elevation, of the corona detection apparatus of the present invention which includes means for automatically providing an alternate corona source whenever a loss of corona is detected.

Fig. 2B is a top view of a portion of the corona source and moving web of Fig. 2A, and a corona sensing conductor positioned near the edge of the spacial current path produced by said corona source.

Fig. 3A is a schematic of a corona sensing conductor similar to that in Fig. 2A except that the conductor is positioned between the corona source and the moving web whose charge is being controlled.

Fig. 3B shows a corona sensing conductor positioned between a corona source and a moving web whose charge is being controlled by said corona source, that is physically supported at two points rather than at one point as in Figs. 2B and 3A.

Fig. 3C is the same as Fig. 3B except that the corona sensing conductor is positioned near the edge of the spacial current path produced by the corona source.

## Description of the Preferred Embodiments

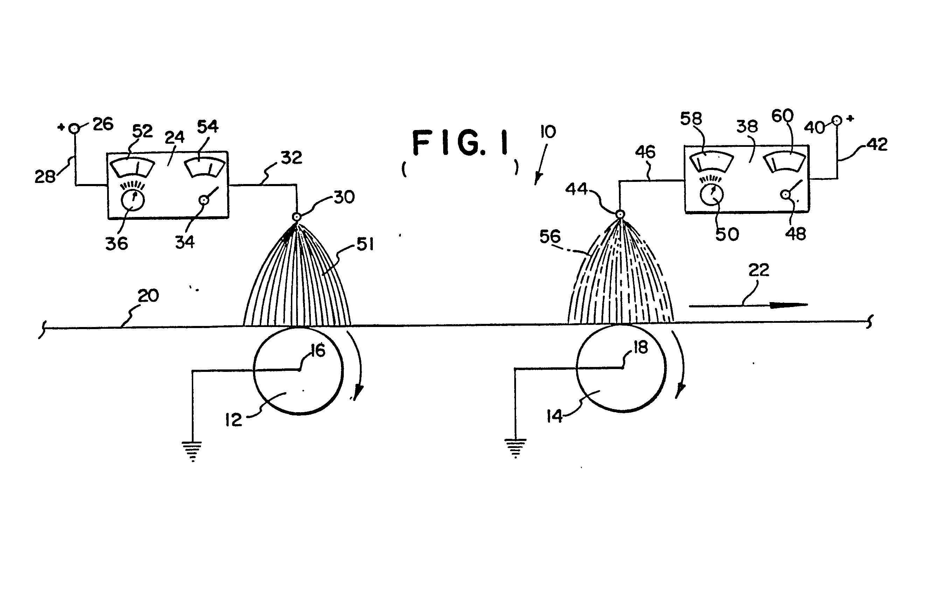

In Figure 1, numeral 10 indicates corona-type electrostatic charge controlling apparatus for controlling charges on a moving web of charge-retaining material constructed in accordance with the teachings of the prior art.

Web support or backing rollers 12 and 14 are cylindrically shaped, are electrically conductive and are mounted for rotation about axes 16 and 18, respectively. Drive means (not shown) move a charge-retaining web 20 in the direction of arrow 22 over backing rollers 12 and 14. As the web 20 is moving the rollers 12 and 14 rotate about axes 16 and 18, respectively, as a result of the frictional engagement of the surface of web 20 with the surface of the rollers 12 and 14.

The input of a primary high voltage power supply 24 is connected to a relatively low voltage source (not shown) at terminal 26 through a path 28. The high voltage output of the power supply 24 is connected to a corona electrode 30 through a path 32. Normally several corona sources are employed per web charging station, but one corona source only has been shown. Power supply 24 is energized by the manual actuation of a switch 34, and the level of the voltage at corona source or electrode 30 is manually adjusted to the desired corona voltage level by knob 36.

Similarly, the input of an alternate high voltage power supply 38 is connected to a relatively low power source (not shown) at terminal 40 through path 42. The high voltage output of said alternate power supply 38 is connected to alternate corona source electrode 44 through path 46. Alternate power supply 38 is energized by the manual actuation of switch 48, and the level of the voltage at alternate corona source or electrode 44 is manually set to the desired corona voltage level by a knob 50.

When the power supply 24 is energized by actuating the switch 34 a high voltage is produced at its output; this produces a corona at corona source 30 and a current or stream of electric charges 51 between said corona source 30 and grounded backing roller 12. The desired corona level is controlled by rotating knob 36 while monitoring voltmeter 52 and/or ammeter 54. Alternatively, the corona levels can be determined empirically by measuring the charge levels on charge-retaining materials after said materials have been subjected to the electric charges 51. When web 20 is passed between electrode 30 and grounded backing roller 12 through current 51 having a predetermined magnitude, the desired electrostatic charge level will be produced on said web 20.

Web 20 is moved between corona source or electrode 44 and grounded backing roller 14 after moving between electrode 30 and backing roller 12. While corona current is present between corona source or electrode 30 and roller 12 no electrostatic charge-controlling corona is present
between alternate source 44 and backing roller 14.
An operator monitors meters 52, 54 to insure a
predetermined range of values. If the meter readings deviate from the predetermined range, it is
assumed that the corona source has failed. When
this happens the operator energizes alternate
power supply 38 by actuating power control switch
48 to its ON position. When power supply 38 is
energized corona source 44 produces a corona
current or a stream of electric charges 56 equal to
current 51 produced by electrode 30; the desired
corona level produced by electrode 44 is established
by the rotation of knob 50 and the monitoring of
meters 58 and 60 on alternate power supply 38. If
alternate power supply 38 is energized promptly
after loss of corona occurs at electrode 30,
there is no interruption in the level of charge
on moving web 20 as long as the web 20 moves
between corona source 44 and backing roller 14
after it moves between corona source 30 and backing
roller 12. A problem with the prior art charge
controlling apparatus of Fig. 1 is that the corona-
loss indication provided by meters 52, 54 on power
supply 24 are not consistently accurate. In many
instances a meter reading will be well within a
predetermined range of values indicating the presence of charge-controlling corona when, in fact,
a corona is not present. The apparatus of the
present invention avoids any interruption of charge
controlling corona by consistently indicating its
presence or lack thereof.

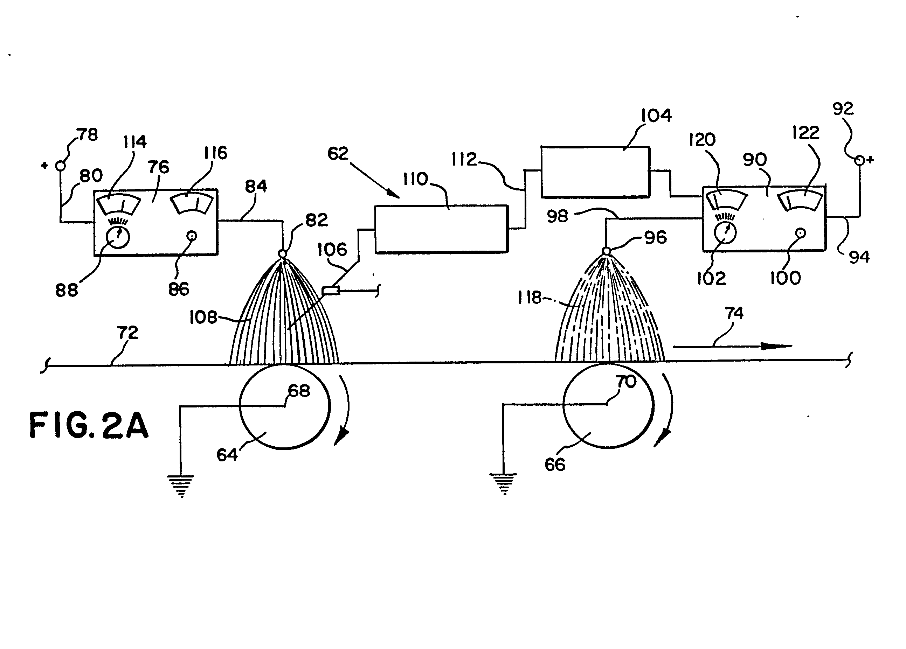

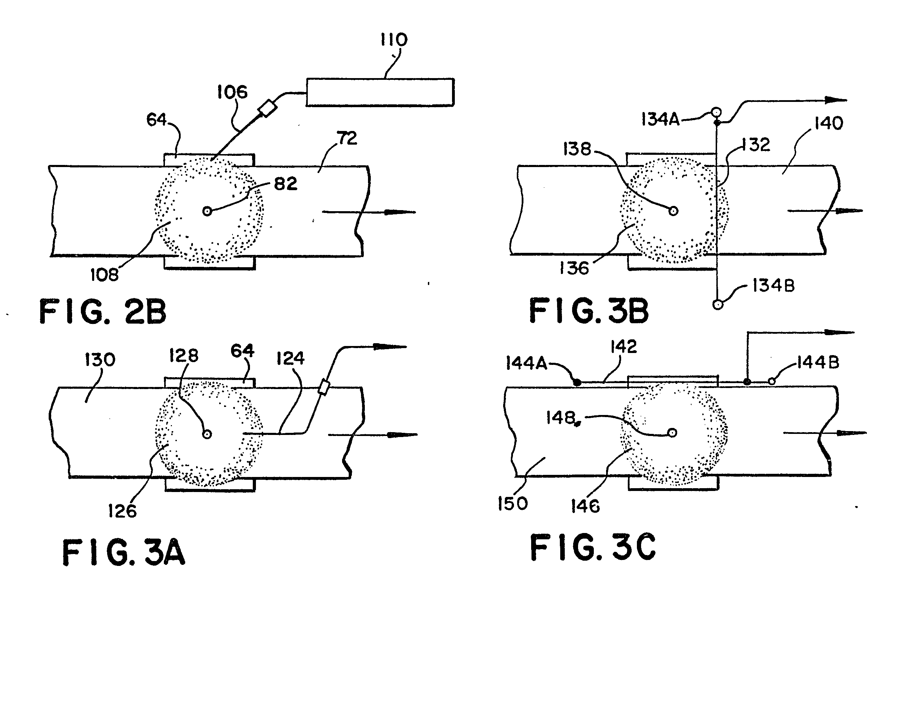

Turning now to Fig. 2, the numeral 62 generally indicates corona-type apparatus for controlling electrostatic charges on a moving web. Web support or backing rollers 64 and 66 are electrically conductive and are mounted for rotation about axes 68 and 70, respectively. Drive means (not shown) are provided to move a web 72 in the direction of arrow 74. As the web 72 is moving, rollers 64 and 66 rotate as a result of the frictional engagement with the surface of web 72.

A high voltage power supply 76 is connected to a voltage source (not shown) at terminal 78 through path 80. The output of the power supply 76 is connected to electrode 82 through path 84. Power supply 76 is energized by the actuation of switch 86, and the voltage level at corona source or electrode 82 is set by a knob 88. Similarly, an alternate high voltage power supply 90 is connected to a power source (not shown) at terminal 92 through path 94. The output of the alternate power supply 90 is connected to alternate corona electrode 96 through path 98. The alternate power supply 90 is energized by a switch 100, and the voltage level at alternate corona electrode 96 is set by a knob 102.

The alternate high voltage power supply 90 may also be energized by switch means 104. When a predetermined current is produced in conductor 106 by impinging current or stream of electric charges 108, switching means 104 has no effect on the energization of alternate power supply 90. However, if the current level in conductor 106 drops below a predetermined level (normally to zero), current amplifier 110 coupled to the conductor 106 generates a signal. This signal is routed to switch means 104 through path 112 causing the switch means 104 to energize power supply 90 through an alternate energization path internal of the power supply.

The power supply 76 is energized by actuating switch 86 to produce a high voltage, a corona at electrode 82 and a current or stream of electric charges 108 between the corona source 82 and grounded backing roller 64. The desired corona level is established by the knob 88 while monitoring voltmeter 114 and/or ammeter 116. When the web 72 passes between electrode 82 and grounded backing roller 64 through the current 108, the desired electrostatic charge level is produced on the web 72.

When the power supply 90 is energized, corona electrode 96 produces a corona current or stream of electric charges 118 equal to the current 108; the desired corona level produced by electrode 96 having previously been established by the monitoring of voltmeter 120 and ammeter 122 on alternate power supply 90.

The web 72 is moved between the corona electrode 96 and the grounded backing roller 66 after it has moved through electrode 82 and backing roller 64. As long as a corona current is present between the electrode 82 and the roller 64 no current flows between the alternate corona source 96 and the backing roller 66. The presence of a corona between the electrode 82 and the roller 64 is detected by the conductor 106 positioned in the stream of electric charges 108. If the charges 108 impinging on the conductor 106 drop below a predetermined level, the current amplifier 110 causes the switch means 104 to energize power supply 90. Alternate power supply 90 is energized as soon as the loss of corona current 108 is detected and, therefore, no interruption in the charge level on moving web 72 occurs as long as the moving web 72 moves between the corona source 96 and the backing roller 66 after it has moved between the corona source 82 and the backing roller 64.

A corona sensing conductor such as conductor 106 may take many forms and may be mounted many different ways. In Fig. 2B, for example, the end of current sensing conductor 106 is positioned near the edge of stream of electric charges 108 and does not interfere with electric charges or ions moving between corona source 82 and web 72. In Fig. 3A, the end of current sensing conductor 124 is positioned in the stream of electric charges 126 between corona electrode 128 and moving web 130 where it interferes slightly with electric charges moving toward said web 130.

In Figs. 3B and 3C a current sensing conductor is shown tautly mounted between a pair of insulative support members. In Fig. 3B conductor 132 extends between support members 134A and 134B. Conductor 132 passes through the path of electric charges 136 moving between corona source 138 and moving web 140. In Fig. 3C conductor 142 extends between support members 144A and 144B, and passes through stream of electric charges 146. In Fig. 3B there is a slight interference with electric charges moving between corona source 138 and web 140. However, in Fig. 3C there is no interference with electric charges moving between corona source 148 and moving web 150.

It will be apparent to those skilled in the art from the foregoing description of my invention that various improvements and modifications may be made without departing from its true scope.

## Claims

1. Apparatus for detecting the presence of corona wherein a spatial electric current is produced by said corona, comprising: an electrical conductor located in the path of said corona-produced current; and means for sensing current in said electrical conductor resulting from electric corona-current charges impinging on said conductor.

2. The apparatus of claim 1, wherein said current sensing means includes a visual indicator.

3. The apparatus of claim 2, wherein said visual indicator is an electrical meter.

4. The apparatus of claim 1, wherein said current sensing means includes an aural indicator.

5. Apparatus for detecting the presence of corona for controlling electrostatic charges on charge-retaining materials, comprising: a primary electrically conductive reference surface; a primary corona source including a stream of electric charges produced by said corona source moving toward said reference surface to control electrostatic charges on charge retaining materials interposed between said corona source and said reference surface; an electrical conductor located in the stream of electric charges produced by said corona source, in which an electric current is produced as a result of a portion of the said corona-produced stream of electric charges impinging on said electrical conductor; and means responsive to the current in said electrical conductor for producing a signal indicative of the presence of the corona that generated said stream of charges.

6. The apparatus of claim 5 further comprising means responsive to said corona signal for visually indicating the presence of the current that produced said corona signal.

7. The apparatus of claim 5, further comprising: an alternate electrically conductive reference surface; an energizable alternate corona source capable of providing an alternate stream of electric charges equivalent to said primary stream of electric charges, between said alternate corona source and said alternate reference surface whenever said alternate corona source is energized; and means responsive to said corona signal for energizing said alternate corona source when the magnitude of said current in said electrical conductor is equal to or less than a predetermined value to thereby insure the uninterrupted movement of charge controlling electric charges to charge-retaining material passed between said primary corona source and said primary reference surface and subsequently between said alternate corona source and said alternate reference surface.

8. The apparatus of claim 7, wherein said electrical conductor is positioned such that it does not interfere with electric charges moving between said corona source and said charge-retaining material passed between said primary corona source and said primary reference surface.

9. The apparatus of claim 5, wherein said current responsive means includes a current amplifier.

10. The apparatus of claim 5, wherein said charge-retaining material is a moving web.

11. The apparatus of claim 5, wherein an end of said electrical conductor projects into the stream of electric charges produced by said primary corona source.

12. The apparatus of claim 5, wherein said electrical conductor is supported between two insulated members.

13. Apparatus for assuring the availability of electrostatic charge controlling corona, comprising:

first and second electrically conductive reference surfaces;

a first corona source for producing a first stream of electric charges between said first corona source and said first reference surface;

a second corona source for producing a second stream of charges between said second corona source and said second reference surface;

an electrical conductor in the path of the said first stream of electric charges produced by said first corona source wherein an electric current is produced in said conductor as a result of a portion of the said first stream of electric charges impinging on said electrical conductor; and

means responsive to the said conductor current in said electrical conductor for energizing said second corona source when the magnitude of the current in said conductor is equal to or less than a predetermined magnitude as a result of loss of corona from said first corona source whereby the uninterrupted availability of corona produced electric charges for controlling the electrostatic charge level on charge-retaining material is thereby assured for material that is initially passed between said first corona source and said first reference surface, and subsequently between said second corona source and said second reference surface.

0081000

FIG. 1

FIG. 2A

FIG. 2B

FIG. 3A

FIG. 3B

FIG. 3C

**European Patent Office**

# EUROPEAN SEARCH REPORT

Application number

EP 81 11 0116.1

| | DOCUMENTS CONSIDERED TO BE RELEVANT | | CLASSIFICATION OF THE APPLICATION (Int. Cl. ³) |
|---|---|---|---|
| Category | Citation of document with indication, where appropriate, of relevant passages | Relevant to claim | |
| X | <u>US - A - 4 228 480</u> (B.R. BENWOOD et al.) <br> * column 2, lines 27 to 41; column 3, lines 12 to 39; column 4, lines 14 to 29; fig. 1 * | 1-5, 11,12 | G 01 R 29/12 <br> H 01 T 19/00 |
| Y | . | 2-4, 6,9 | |
| | -- | | **TECHNICAL FIELDS SEARCHED (Int.Cl. ³)** |
| Y | <u>US - A - 3 774 110</u> (D. ROVETI) <br> * column 2, lines 1 to 3, 23 to 32; fig. 1 * | 2-4,6, 9 | |
| | -- | | |
| A | XEROX DISCLOSURE JOURNAL <br> Vol. 4, No. 5, September/October 1979 <br> P.F. CLARK et al. "Controlling the Output of Corona Devices" <br> page 603 <br> * page 603 * | 7,13 | G 01 R 29/12 <br> H 01 T 19/00 |
| | ---- | | |

**CATEGORY OF CITED DOCUMENTS**

X: particularly relevant if taken alone
Y: particularly relevant if combined with another document of the same category
A: technological background
O: non-written disclosure
P: intermediate document
T: theory or principle underlying the invention
E: earlier patent document, but published on, or after the filing date
D: document cited in the application
L: document cited for other reasons

&: member of the same patent family, corresponding document

| X | The present search report has been drawn up for all claims | | |
|---|---|---|---|
| Place of search | Date of completion of the search | Examiner | |
| Berlin | 20-07-1982 | LEMMERICH | |

EPO Form 1503.1  06.78